# EUROPEAN PATENT APPLICATION

(11) **EP 4 175 424 A1**
(43) Date of publication of application: **03.05.2023**
(21) Application number: 22830351.7
(22) Date of filing: 18.08.2022
(51) Int. Cl.: H05K 1/14, H05K 3/36

(54) **CIRCUIT BOARD ASSEMBLY AND ELECTRONIC DEVICE**

(30) Priority: 18.09.2021 CN 202111112899
(71) Applicant: Honor Device Co., Ltd., Shenzhen, Guangdong 518040 (CN)
(72) Inventor: GUO, Jianqiang, Shenzhen, Guangdong 518040 (CN); LUO, Wenjun, Shenzhen, Guangdong 518040 (CN)
(74) Representative: Körber, Martin Hans
(86) International application number: PCT/CN2022/113329
(87) International publication number: WO 2023/040570

(57) **Abstract**

Embodiment of this application provide a circuit board assembly and an electronic device. The circuit board assembly is applied to an electronic device. The circuit board assembly includes at least printed circuit boards, a flexible circuit board, and a support. Two or more printed circuit boards are spaced apart. The printed circuit boards include first pads. Two neighboring printed circuit boards are connected to the flexible circuit board. The flexible circuit board includes a bending region, straight regions, and second pads. Straight regions are respectively arranged on two opposite sides of the bending region. The straight regions are located between the two printed circuit boards. The bending region and the straight regions form an accommodating space. The second pad is arranged in the straight region. The first pad is connected to the second pad. The support is arranged in the accommodating space. The support includes two stacked support bodies. The support body is abutted against the straight region to apply a compressive stress toward the printed circuit board to the straight region. The circuit board assembly according to the embodiments of this application can reduce the possibility that a bending flexible circuit board is prone to tearing at a joint with a printed circuit board.

## Description

This application claims priority to Chinese Patent Application No. 202111112899.2, filed with the China National Intellectual Property Administration on September 18, 2021 and entitled "CIRCUIT BOARD ASSEMBLY AND ELECTRONIC DEVICE", which is incorporated herein by reference in its entirety.

### TECHNICAL FIELD

Embodiments of this application relate to the field of terminal technologies, and in particular, to a circuit board assembly and an electronic device.

### BACKGROUND

As electronic products are developed toward high-density packaging, to provide a larger arrangement space for the battery and other functional modules in the electronic device, at present, a plurality of printed circuit boards (Printed Circuit Board, PCB) are usually arranged in a stacked manner. In the manner of stacking a plurality of printed circuit boards, electronic components can be distributed and arranged on the printed circuit boards, so that all the electronic components can be arranged without increasing the area of the printed circuit boards.

In the manner of stacking a plurality of printed circuit boards, two printed circuit boards are electrically connected to each other by a flexible circuit board (Flexible Printed Circuit, FPC), so that electrical signals can be transmitted between the two printed circuit boards through the flexible circuit board. The flexible circuit board is connected to the printed circuit boards in a soldering manner by their respective pads. After the printed circuit boards are stacked, the flexible circuit board is in a bending state. However, the bending flexible circuit board is prone to tearing at a joint with the printed circuit board, resulting in damage of the flexible circuit board and failure of the flexible circuit board in normal working.

### SUMMARY

The embodiments of this application provide a circuit board assembly and an electronic device, to reduce the possibility that a bending flexible circuit board is prone to tearing at a joint with a printed circuit board.

A first aspect of this application provides a circuit board assembly. The circuit board assembly is applied to an electronic device. The circuit board assembly includes at least printed circuit boards, a flexible circuit board, and a support. Two or more printed circuit boards are spaced apart. The printed circuit boards include first pads. Two neighboring printed circuit boards are connected to the flexible circuit board. The flexible circuit board includes a bending region, straight regions, and second pads. Straight regions are respectively arranged on two opposite sides of the bending region. The straight regions are located between the two printed circuit boards. The bending region and the straight regions form an accommodating space. The second pad is arranged in the straight region. The first pad is connected to the second pad. The support is arranged in the accommodating space. The support includes two stacked support bodies. The support body is abutted against the straight region to apply a compressive stress toward the printed circuit board to the straight region.

In the embodiments of this application, the circuit board assembly includes a bending flexible circuit board and stacked printed circuit boards and the bending flexible circuit board. The bending flexible circuit board includes a bending region and straight regions. The straight regions are connected to the printed circuit boards. A support is arranged in an accommodating space formed by the bending region and the straight regions. The support includes two stacked support bodies. The two support bodies abut each other. One support body is abutted against one of the straight region, and the other support body is abutted against an other straight region. The two support bodies can respectively apply compressive stresses toward the printed circuit boards to the corresponding straight regions, to make the fitting between the straight regions and the printed circuit boards more snugly and relative positions between the straight regions and the printed circuit boards uneasy to change, thereby improving the stability and reliability of the connections between the straight regions and the printed circuit boards. When the flexible circuit board is subjected to an external force or its own rebound stress, the straight regions of the flexible circuit board are uneasy to have position changes relative to the printed circuit boards, thereby effectively reducing the possibility that due to movement of the straight regions, the straight regions and the printed circuit boards are torn at joints formed by the first pads and the second pads.

In a possible implementation, the flexible circuit board includes a flexible dielectric layer. The second pads are connected to the flexible dielectric layer. The support body is abutted against the flexible dielectric layer. Because the support bodies limit and restrain the straight regions, when the bending region is subjected to an external force, for example, when the bending region is squeezed and collided, or the bending region is subjected to its down rebound stress, the acting force is unlikely to be transferred from the flexible dielectric layer of the bending region to the flexible dielectric layers of the straight regions, so that the tensile force is unlikely to act between the flexible dielectric layer and the second pads, thereby effectively reducing the possibility that due to bearing a relatively large tensile force, the flexible dielectric layer is separated from the second pads and torn, and also reducing the possibility that due to bearing a relatively large tensile force, the second pads are separated from the first pads.

In a possible implementation, the second pad is at least partially arranged between the support body and the printed circuit board. The support body may be abutted against the flexible dielectric layer close to the second pad, to help reduce the possibility of separation between the flexible dielectric layer and the second pad caused by a position change of the flexible dielectric layer near the second pad relative to the second pad after the flexible dielectric layer is subjected to a force.

In a possible implementation, the support body is an elastomer. When being subjected to an external force, the support body itself can compress and deform. Because the support bodies can compress and deform, when there are different requirements for the distance between the two printed circuit boards, the support bodies can also be well adapted to the space change, thereby reducing the possibility of relatively high production costs and assembly costs caused by the machining and manufacturing of support bodies of different sizes.

In a possible implementation, the support body includes a bottom surface facing toward the straight region. At least a part of the bottom surface is connected to the straight region. A part of the support body close to the bending region is connected to the flexible circuit board, and a part thereof away from the bending region is in contact with, but is not connected to, the flexible circuit board. Therefore, on the one hand, after connections between the two printed circuit boards and the flexible circuit board are completed, the support body is connected to a predetermined position of the flexible circuit board, and then, the two printed circuit boards are further stacked, and the flexible circuit board is bent, which is beneficial to ensuring the precision of the mounting position of the support body. On the other hand, in the circuit board assembly that has been completely assembled, when the support body is subjected to an external force, the support body is unlikely to be misplaced, thereby reducing the possibility that the support body cannot be abutted against the straight region anymore because misplacement of the support body releases the two support bodies from a stacked state.

In a possible implementation, a cross-sectional area of the support body decreases along a direction away from the second pad.

In a possible implementation, a cavity is formed between the support body and the straight region. The second pad is located in the cavity. The second pad is entirely located in the cavity, so that the support body can avoid the second pad and the protruding part of the solder j oint. A region in which the support body is in contact with the straight region surrounds the second pad and the protruding part of the solder joint, so that the support body can compress a region of the flexible dielectric layer surrounding the second pad tightly. The manner in which the support body avoids the second pad can reduce the possibility that the support body cannot be abutted against a region of the flexible dielectric layer near the second pad due to a gap formed between the support body and the region of the flexible dielectric layer near the second pad caused by the protruding part of the solder joint supporting the support body.

In a possible implementation, the top surface of the support body facing away from the second pad is a curved surface. When the two support bodies abut each other, the respective top surfaces of the two support bodies are unlikely to have a stress concentration region.

In a possible implementation, the top surface of the support body facing away from the second pad is a flat surface.

In a possible implementation, a top surface of the support body facing away from the second pad includes a first flat surface and second flat surface, where the first flat surface intersects the second flat surface.

In a possible implementation, each support body is arranged in correspondence to two or more second pads, so that after the printed circuit boards are folded and stacked, each support body can simultaneously apply a compressive stress to regions of the flexible dielectric layer surrounding a plurality of second pads.

In a possible implementation, two or more supports are arranged in in the accommodating space of the flexible circuit board. A quantity and positions of the supports have a one-to-one correspondence with a quantity and positions of the second pads. Two neighboring supports are spaced apart from each other. Adopting the manner of dispersing a plurality of supports, on the one hand, is beneficial to reducing the material usage of the supports and reducing production costs, and on the other hand, can reduce airflow blockage caused by the supports since the two neighboring support bodies are spaced apart, which is beneficial to flowing of airflows and ensures good heat dissipation.

In a possible implementation, the support body is bonded to the straight region. Use of a bonding manner can reduce a quantity of used connectors, and does not require correspondingly designing the structure of the support body or the straight region of the flexible circuit board to adapt to connectors, which is beneficial to reducing the complexity of structural machining of the support body and the flexible circuit board and the difficulty of assembly of the support body and the flexible circuit board.

In a possible implementation, an inner surface of the bending region facing toward the accommodating space comes into contact with the support body. The support body can provide a supporting force to the bending region in the contact region, which is beneficial to reducing the possibility that the bending region is depressed toward the accommodating space after being subjected to an acting force, thereby, on the one hand, reducing the possibility that the bending region pulls the straight region due to the depression of the bending region, to make the straight region be subjected to a relatively large tensile force and be torn, and on the other hand, reducing the possibility that the metal traces of the bending region are folded and broken due to the depression of the bending region.

A second aspect of the embodiments of this application provides an electronic device, including the circuit board assembly according to the foregoing embodiment.

The circuit board assembly includes at least printed circuit boards, a flexible circuit board, and a support. For the printed circuit boards, two or more printed circuit boards are spaced apart. The printed circuit boards include first pads. Two neighboring printed circuit boards are connected to the flexible circuit board. The flexible circuit board includes a bending region, straight regions, and second pads. Straight regions are respectively arranged on two opposite sides of the bending region. The straight regions are located between the two printed circuit boards. The bending region and the straight regions form an accommodating space. The second pad is arranged in the straight region. The first pad is connected to the second pad. The support is arranged in the accommodating space. The support includes two stacked support bodies. The support body is abutted against the straight region to apply a compressive stress toward the printed circuit board to the straight region.

In a possible implementation, the flexible circuit board includes a flexible dielectric layer. The second pads are connected to the flexible dielectric layer. The support body is abutted against the flexible dielectric layer. Because the support bodies limit and restrain the straight regions, when the bending region is subjected to an external force, for example, when the bending region is squeezed and collided, or the bending region is subjected to its down rebound stress, the acting force is unlikely to be transferred from the flexible dielectric layer of the bending region to the flexible dielectric layers of the straight regions, so that the tensile force is unlikely to act between the flexible dielectric layer and the second pads, thereby effectively reducing the possibility that due to bearing a relatively large tensile force, the flexible dielectric layer is separated from the second pads and torn, and also reducing the possibility that due to bearing a relatively large tensile force, the second pads are separated from the first pads.

In a possible implementation, the second pad is at least partially arranged between the support body and the printed circuit board. The support body may be abutted against the flexible dielectric layer close to the second pad, to help reduce the possibility of separation between the flexible dielectric layer and the second pad caused by a position change of the flexible dielectric layer near the second pad relative to the second pad after the flexible dielectric layer is subjected to a force.

In a possible implementation, the support body is an elastomer. When being subjected to an external force, the support body itself can compress and deform. Because the support bodies can compress and deform, when there are different requirements for the distance between the two printed circuit boards, the support bodies can also be well adapted to the space change, thereby reducing the possibility of relatively high production costs and assembly costs caused by the machining and manufacturing of support bodies of different sizes.

In a possible implementation, the support body includes a bottom surface facing toward the straight region. At least a part of the bottom surface is connected to the straight region. A part of the support body close to the bending region is connected to the flexible circuit board, and a part thereof away from the bending region is in contact with, but is not connected to, the flexible circuit board. Therefore, on the one hand, after connections between the two printed circuit boards and the flexible circuit board are completed, the support body is connected to a predetermined position of the flexible circuit board, and then, the two printed circuit boards are further stacked, and the flexible circuit board is bent, which is beneficial to ensuring the precision of the mounting position of the support body. On the other hand, in the circuit board assembly that has been completely assembled, when the support body is subjected to an external force, the support body is unlikely to be misplaced, thereby reducing the possibility that the support body cannot be abutted against the straight region anymore because misplacement of the support body releases the two support bodies from a stacked state.

In a possible implementation, a cross-sectional area of the support body decreases along a direction away from the second pad.

In a possible implementation, a cavity is formed between the support body and the straight region. The second pad is located in the cavity. The second pad is entirely located in the cavity, so that the support body can avoid the second pad and the protruding part of the solder j oint. A region in which the support body is in contact with the straight region surrounds the second pad and the protruding part of the solder joint, so that the support body can compress a region of the flexible dielectric layer surrounding the second pad tightly. The manner in which the support body avoids the second pad can reduce the possibility that the support body cannot be abutted against a region of the flexible dielectric layer near the second pad due to a gap formed between the support body and the region of the flexible dielectric layer near the second pad caused by the protruding part of the solder joint supporting the support body.

In a possible implementation, the top surface of the support body facing away from the second pad is a curved surface. When the two support bodies abut each other, the respective top surfaces of the two support bodies are unlikely to have a stress concentration region.

In a possible implementation, the top surface of the support body facing away from the second pad is a flat surface.

In a possible implementation, a top surface of the support body facing away from the second pad includes a first flat surface and second flat surface, where the first flat surface intersects the second flat surface.

In a possible implementation, each support body is arranged in correspondence to two or more second pads, so that after the printed circuit boards are folded and stacked, each support body can simultaneously apply a compressive stress to regions of the flexible dielectric layer surrounding a plurality of second pads.

In a possible implementation, two or more supports are arranged in in the accommodating space of the flexible circuit board. A quantity and positions of the supports have a one-to-one correspondence with a quantity and positions of the second pads. Two neighboring supports are spaced apart from each other. Adopting the manner of dispersing a plurality of supports, on the one hand, is beneficial to reducing the material usage of the supports and reducing production costs, and on the other hand, can reduce airflow blockage caused by the supports since the two neighboring support bodies are spaced apart, which is beneficial to flowing of airflows and ensures good heat dissipation.

In a possible implementation, the support body is bonded to the straight region. Use of a bonding manner can reduce a quantity of used connectors, and does not require correspondingly designing the structure of the support body or the straight region of the flexible circuit board to adapt to connectors, which is beneficial to reducing the complexity of structural machining of the support body and the flexible circuit board and the difficulty of assembly of the support body and the flexible circuit board.

In a possible implementation, an inner surface of the bending region facing toward the accommodating space comes into contact with the support body. The support body can provide a supporting force to the bending region in the contact region, which is beneficial to reducing the possibility that the bending region is depressed toward the accommodating space after being subjected to an acting force, thereby, on the one hand, reducing the possibility that the bending region pulls the straight region due to the depression of the bending region, to make the straight region be subjected to a relatively large tensile force and be torn, and on the other hand, reducing the possibility that the metal traces of the bending region are folded and broken due to the depression of the bending region.

### BRIEF DESCRIPTION OF DRAWINGS

FIG. 1 is a schematic structural diagram of an electronic device according to an embodiment of this application;
FIG. 2 is a partial schematic exploded structural view of an electronic device according to an embodiment of this application;
FIG. 3 is a schematic structural diagram of a printed circuit board in the related art;
FIG. 4 is a partial schematic structural diagram of a circuit board assembly in the related art;
FIG. 5 is a partial schematic cross-sectional structural view of a flexible circuit board in the related art;
FIG. 6 is an enlarged view of a position A in FIG. 4;
FIG. 7 is a partial schematic cross-sectional structural view of arranging solder paste on a pad of a printed circuit board;
FIG. 8 is a schematic diagram of a first state in which a printed circuit board, solder paste, and a flexible circuit board are connected;
FIG. 9 is a schematic diagram of a second state in which a printed circuit board, solder paste, and a flexible circuit board are connected;
FIG. 10 is a partial schematic cross-sectional structural view of a connected state between a printed circuit board and a flexible circuit board;
FIG. 11 is a schematic diagram of a flexible dielectric layer and a solder pin being in a separated state;
FIG. 12 is a schematic structural diagram of a circuit board assembly according to an embodiment of this application;
FIG. 13 is an enlarged view of a position B in FIG. 12;
FIG. 14 is a partial schematic cross-sectional structural view of a circuit board assembly according to an embodiment of this application;
FIG. 15 is a partial schematic cross-sectional structural view of a circuit board assembly according to another embodiment of this application;
FIG. 16 is a partial schematic cross-sectional structural view of a circuit board assembly according to still another embodiment of this application in a first state;
FIG. 17 is a partial schematic cross-sectional structural view of the circuit board assembly according to the embodiment shown in FIG. 16 in a second state;
FIG. 18 is a partial schematic cross-sectional structural view of a circuit board assembly according to still another embodiment of this application in a first state;
FIG. 19 is a partial schematic cross-sectional structural view of the circuit board assembly according to the embodiment shown in FIG. 18 in a second state; and
FIG. 20 is a partial schematic cross-sectional structural view of a circuit board assembly according to yet another embodiment of this application in a first state.

### REFERENCE NUMERALS:

10. electronic device;
20. display assembly;
30. middle frame;
40. circuit board assembly;
41. printed circuit board; 41a. soldering region; 411. first pad; 412. metal wire; 413. stopping portion;
42. flexible circuit board; 42a. bending region; 42aa. inner surface; 42b. straight region; 42c. accommodating space;
421. flexible dielectric layer; 4211. through hole;
422. second pad; 422a. middle channel;
423. metal trace;
50. rear housing;
60. electronic component;
70. solder paste;
80. solder joint;
90. support; 91. support body; 911. bottom surface; 912. top surface; 912a. first flat surface; 912b. second flat surface;
100. cavity.

### DESCRIPTION OF EMBODIMENTS

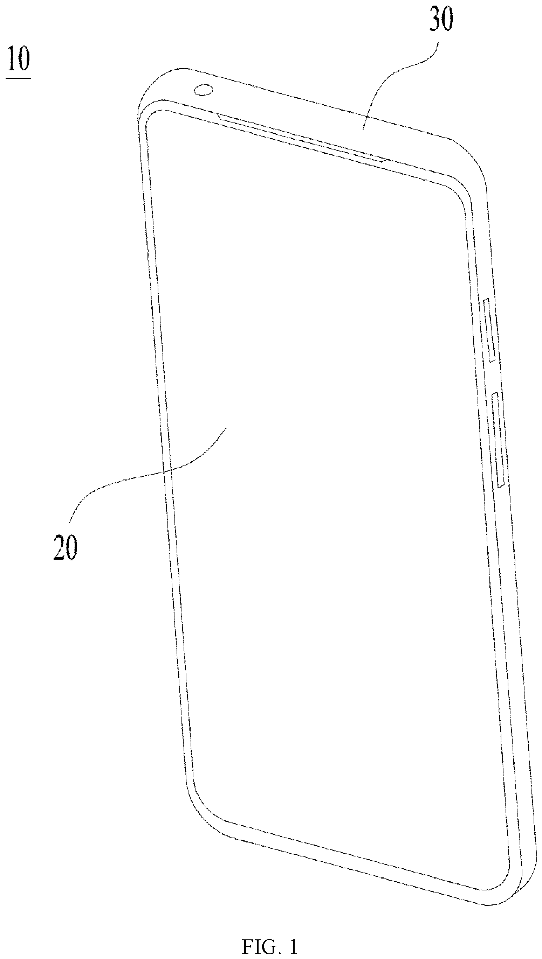

FIG. 1 schematically shows a structure of an electronic device 10 according to an embodiment. Referring to FIG. 1, the embodiments of this application provide an electronic device 10. The electronic device 10 may be a mobile terminal, a fixed terminal, or a foldable device, for example, a monitor, a handheld wireless communication device, a desktop computer, a notebook computer (laptop), a tablet computer (Tablet), an ultra-mobile personal computer (Ultra-mobile Personal Computer, UMPC), a handheld computer, an intercom, a netbook, a POS terminal, or a personal digital assistant (Personal Digital Assistant, PDA).

For ease of description of the following embodiments, descriptions are provided by using an example in which the electronic device 10 is a handheld wireless communication device. The handheld wireless communication device may be a mobile phone.

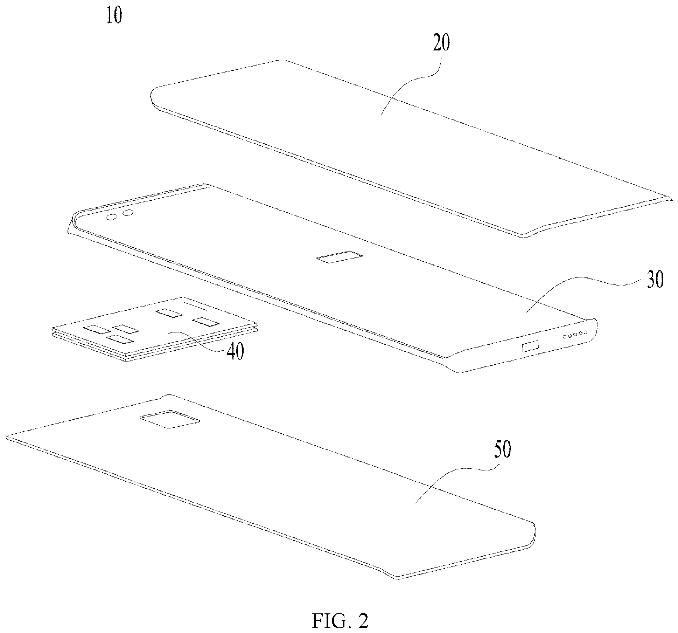

FIG. 2 schematically shows an exploded structure of the electronic device 10 according to an embodiment. Referring to FIG. 2, the electronic device 10 includes a display assembly 20, a middle frame 30, a circuit board assembly 40, and a rear housing 50. The display assembly 20 includes a display region configured to display image information. The display region faces away from the middle frame 30. In a powered state, the display region can display corresponding image information. The middle frame 30 is arranged between the display assembly 20 and the rear housing 50 along a thickness direction of the electronic device 10. It should be noted that the thickness direction of the electronic device 10 refers to an arrangement direction of the display assembly 20 and the rear housing 50. The circuit board assembly 40 is arranged in a space formed between the middle frame 30 and the rear housing 50. The circuit board assembly 40 may be arranged on a surface of the middle frame 30 facing toward the rear housing 50.

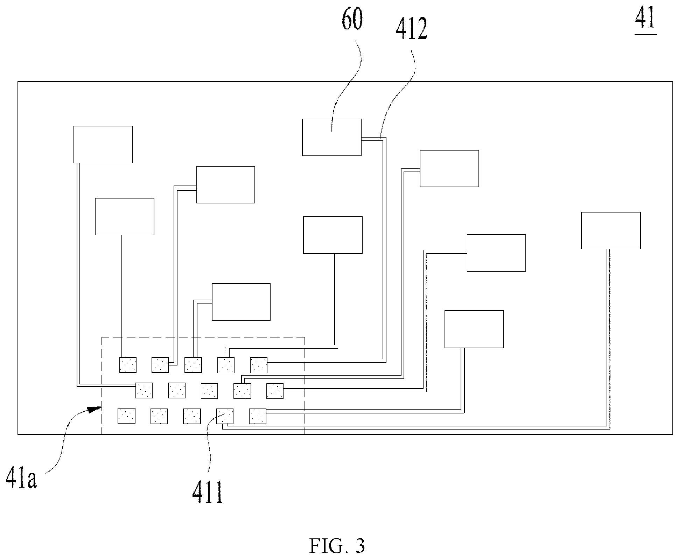

FIG. 3 schematically shows an exploded structure of a printed circuit board 41 according to an embodiment. Referring to FIG. 2 and FIG. 3, the circuit board assembly 40 may include a printed circuit board 41 (Printed Circuit Board, PCB) and a plurality of electronic components 60 electrically connected to the printed circuit board 41. The printed circuit board 41 may be a hard board that does not bend easily. The printed circuit board 41 may be a single-side board or a double-side board. The single-side board means that the electronic components 60 are arranged on one side of the printed circuit board 41. The double-side board means that the electronic components 60 are arranged on both sides of the printed circuit board 41. The printed circuit board 41 may be a radio frequency (radio frequency, RF) board or an application processor (application processor, AP) board. The radio frequency board may be configured to carry a radio frequency chip (radio frequency integrated circuit, RFIC), a radio frequency power amplifier (radio frequency power amplifier, RFPA), a wireless fidelity (wireless fidelity, WIFI) chip, and the like, but is not limited thereto. The application processor board, for example, may be configured to carry a system on chip (system on chip, SOC) element, a double data rate (double data rate, DDR) memory, a primary power supply management chip (power management unit, PMU), a secondary power supply management chip, and the like, but is not limited thereto.

In a case that, for example, the thickness of the electronic device 10 is relatively small, but the display assembly 20 is relatively large, the printed circuit board 41 may have a relatively large lateral size, so that one printed circuit board 41 can be selected to use, and a fixed quantity of electronic components 60 are arranged on the one printed circuit board 41. The lateral size refers to a size measures in a direction perpendicular to the thickness direction of the electronic device. If there are a relatively large quantity of electronic components 60 that have a relatively large volume, resulting in a failure in using one printed circuit board 41 to accommodate all the electronic components 60, the structure of the circuit board assembly 40 needs to be optimized, for example, a plurality of printed circuit boards 41 are stacked along the thickness direction of the electronic device 10, and the electronic components 60 are arranged on different printed circuit boards 41, so as to make full use of the interior space of the electronic device 10 in the thickness direction of the electronic device 10, thereby accommodating more and larger electronic components 60. The plurality of printed circuit boards 41 being stacked means that two or more printed circuit boards 41 are spaced apart along their thickness direction. In two neighboring printed circuit boards 41, a surface of one printed circuit board 41 for arranging electronic components 60 faces toward a surface of the other printed circuit board 41 for arranging electronic components 60. There is a predetermined distance between the two neighboring printed circuit boards 41, so that the space between the two printed circuit boards 41 can accommodate electronic components 60, to reduce the possibility of position interference between the electronic components 60 respectively arranged on the printed circuit boards 41. For example, a support column may be arranged between the two neighboring printed circuit boards 41, so that the two printed circuit boards 41 are supported through the support column.

Referring to FIG. 3, a soldering region 41a is arranged on a side of the printed circuit board 41. A plurality of first pads 411 are arranged in the soldering region 41a. The plurality of first pad 411 are arranged in a plurality of rows. The first pads 411 of the printed circuit board 41 are electrically connected to the electronic components 60 arranged on the printed circuit board 41 through metal wires 412 on the printed circuit board 41. For example, materials of the metal wire 412 and the first pad 411 may be, but are not limited to, copper or a copper alloy.

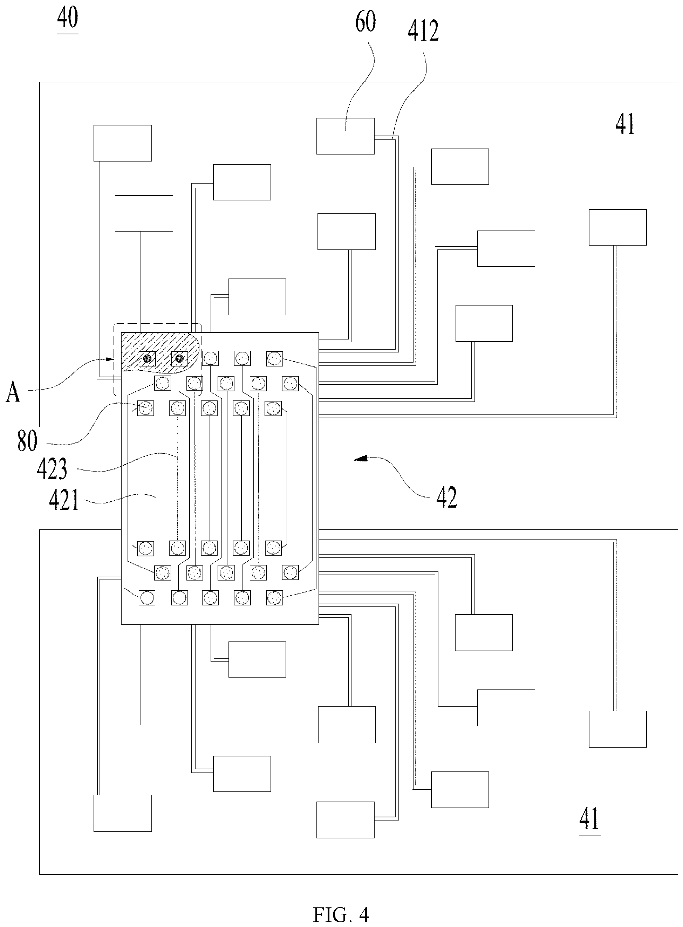

FIG. 4 schematically shows a structure of a circuit board assembly 40 in the related art. Referring to FIG. 3 and FIG. 4, in the related art, the circuit board assembly 40 further includes a flexible circuit board 42 (Flexible Printed Circuit, FPC). The flexible circuit board 42 itself has flexibility, and is easy to bend and deform. The flexible circuit board 42 is configured to conduct corresponding electronic components 60 on two printed circuit boards 41. The two printed circuit boards 41 can transmit electrical signals to each other through the flexible circuit board 42. One end of the flexible circuit board 42 is connected to one of the printed circuit boards 41, and an other end thereof is connected to the other printed circuit board 41. After the two printed circuit boards 41 are stacked, the flexible circuit board 42 is in a bending state. To reduce the volume of the circuit board assembly 40 including the printed circuit boards 41 and the flexible circuit board 42, the flexible circuit board 42 is directly connected to the printed circuit boards 41, so that the flexible circuit board 42 may not be connected to the printed circuit boards 41 by using board-to-board (board to board, BTB) connectors. The flexible circuit board 42 may be connected to the printed circuit boards 41 in a soldering manner.

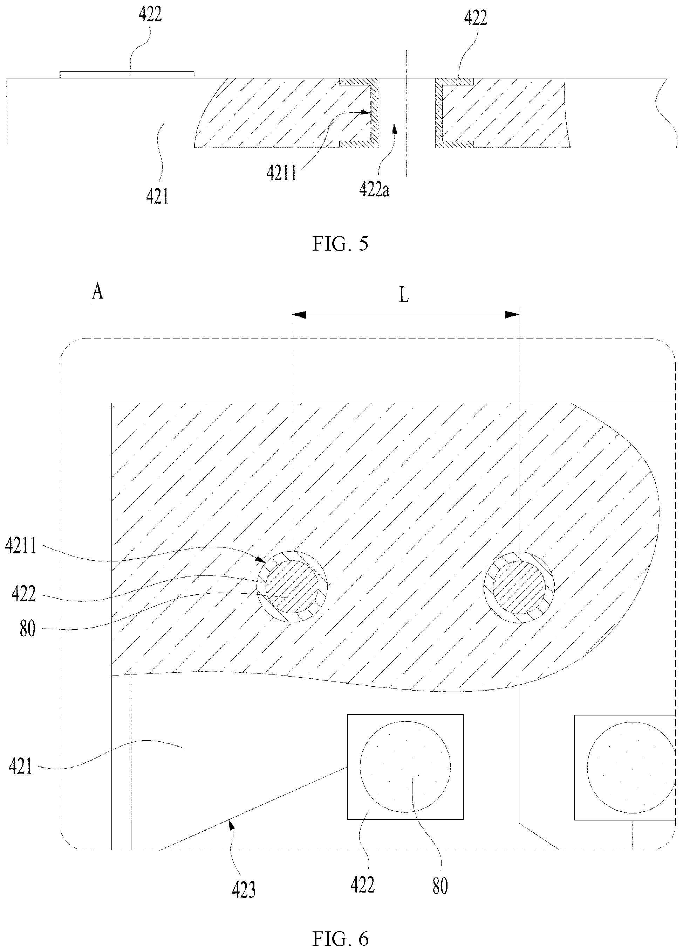

FIG. 5 schematically shows a partial structure of a flexible circuit board 42 according to an embodiment. Referring to FIG. 4 and FIG. 5, the flexible circuit board 42 includes a flexible dielectric layer 421, second pads 422, and metal traces 423. The flexible dielectric layer 421 may be a structure with an insulation function. The flexible dielectric layer 421 is configured to maintain an insulation state between the metal traces 423 or the second pads 422. The material of the flexible dielectric layer 421 includes, but is not limited to, polyimide (Polyimide, PI), thermoplastic polyimide (Thermoplastic polyimide, TPI), polyester (Polyethylene terephthalate, PET). The flexible dielectric layer 421 has good flexibility, and therefore, can bend when being subjected to an external force. A value of the thickness of the flexible dielectric layer 421 ranges from 0.05 mm to 0.5 mm, and for example, may be, but is not limited to, 0.05 mm, 0.075 mm, 0.1 mm, 0.11 mm, 0.2 mm, 0.3 mm, 0.4 mm, and 0.5 mm. The second pads 422 and the metal traces 423 are all arranged in the flexible dielectric layer 421. The flexible circuit board 42 includes a plurality of metal traces 423 and a plurality of second pads 422. The plurality of second pads 422 are usually arranged in a region in a centralized manner, and the plurality of second pads 422 are arranged in a plurality of columns. Different metal traces 423 are connected to corresponding second pads 422. The flexible circuit board 42 is soldered and connected to the corresponding first pads 411 on the printed circuit boards 41 by the second pads 422, so that conduction between the flexible circuit board 42 and the printed circuit boards 41 is implemented. For example, materials of the second pad 422 and the metal trace 423 may be, but are not limited to, copper or a copper alloy.

Referring to FIG. 4 to FIG. 6, in the related art, the flexible dielectric layer 421 of the flexible circuit board 42 is provided with through holes 4211. For example, the through hole 4211 may be a circular hole. Along the thickness direction of the flexible dielectric layer 421, the flexible dielectric layer 421 includes two opposite surfaces, and the through holes 4211 run through the two surfaces of the flexible dielectric layer 421. For example, the through holes 4211 may be formed on the flexible dielectric layer 421 through laser ablation or mechanical drilling. A quantity of the through holes 4211 is equal to a quantity of the second pads 422. In each column of through holes 4211, a predetermined distance L needs to be maintained between two neighboring through holes 4211. For example, the predetermined distance L may be 0.6 mm. The predetermined distance L between the two neighboring through holes 4211 refers to a vertical distance between axes of the neighboring through holes 4211. The second pad 422 is at least partially arranged on an inner wall of the through hole 4211 and is connected to the flexible dielectric layer 421. For example, the second pad 422 may be formed on the flexible dielectric layer 421 through electroless plating. The second pad 422 is connected to the flexible dielectric layer 421, and there is a predetermined bonding force therebetween. The second pad 422 includes a middle channel 422a extending along a thickness direction of the flexible dielectric layer 421. For example, the shape of the middle channel 422a is the same as the shape of the through hole 4211. That is, the middle channel 422a may be a circular hole. For example, a diameter of the middle channel 422a may be, but is not limited to, 0.15 mm, 0.2 mm, or 0.4 mm.

It should be noted that if a predetermined quantity of first pads 411 are arranged on the printed circuit boards 41, a same quantity of second pads 422 may also be arranged on the flexible circuit board 42. One first pad 411 is arranged in correspondence to one second pad 422. For example, if 30 first pads 411 are arranged on the printed circuit boards 41, 30 second pads 422 may also be arranged on the flexible circuit board 42.

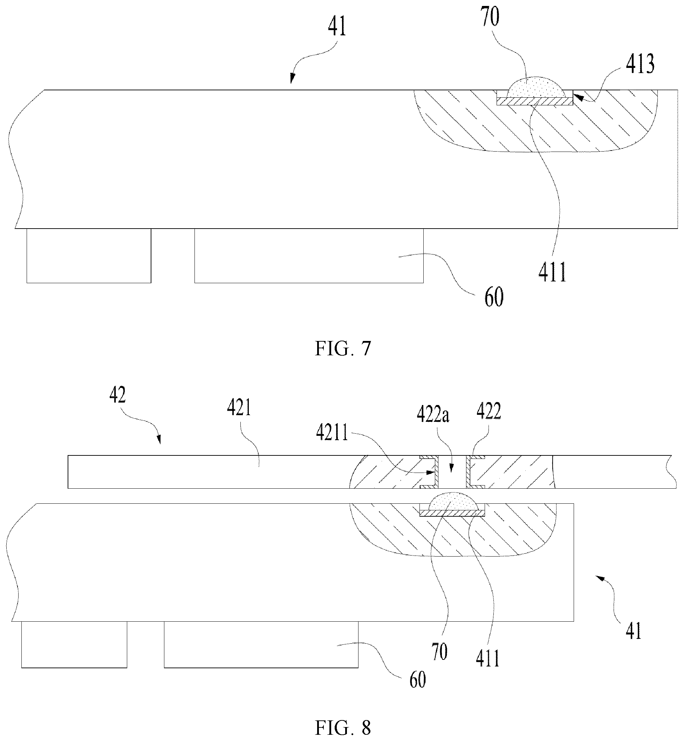

FIG. 7 to FIG. 10 schematically show a process of connecting the flexible circuit board 42 and the printed circuit boards 41. In some feasible manners, the process of connecting the flexible circuit board 42 and the printed circuit boards 41 is as follows:

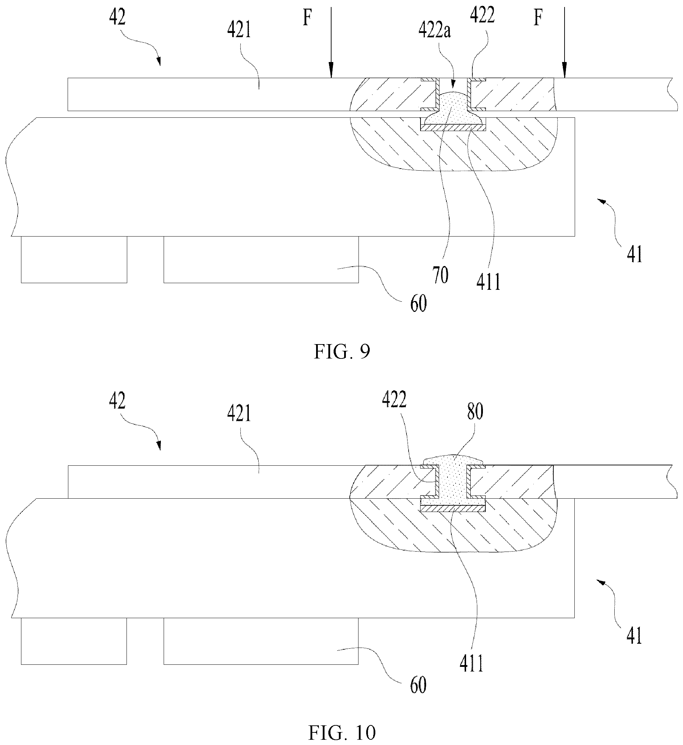

Referring to FIG. 7, solder paste 70 is printed on the first pads 411 on the printed circuit boards 41 in advance. For example, the solder paste 70 may include metal tin and solder flux. Referring to FIG. 8, the second pads 422 of the flexible circuit board 42 are made come into contact with the corresponding first pads 411 of the printed circuit boards 41 through the solder paste 70. Referring to FIG. 9, along the thickness direction of the printed circuit boards 41, on a side of the flexible circuit board 42 facing away from the first pads 411, a compressive stress toward the first pads 411 is applied onto a region on the flexible circuit board 42 in which the second pads 422 are arranged. The solder paste 70 between the second pads 422 and the corresponding first pads 411 is heated. For example, the solder paste 70 is heated by laser. The solder paste 70 melts after absorbing heat. Because the flexible circuit board 42 and the printed circuit board 41 can extrude the melted solder paste 70, a part of the melted solder paste 70 enters the middle channel 422a of the second pad 422. The solder paste 70 rises in the middle channel 422a of the second pad 422 along the thickness direction of the flexible dielectric layer 421. Referring to FIG. 10, after the solder paste 70 is cured, the solder paste 70 forms solder joints 80, so that the second pads 422 of the flexible circuit board 42 are connected to the corresponding first pads 411 of the printed circuit boards 41 by the solder joints 80 and implement conduction.

For example, the solder paste 70 rises in the middle channel 422a of the second pad 422 along the thickness direction of the flexible dielectric layer 421, and overflows from an opening of the middle channel 422a facing away from the first pad 411. The overflowing solder paste 70 can cover the opening of the middle channel 422a facing away from the first pad 411.

For example, the solder paste 70 between the second pad 422 of the flexible circuit board 42 and the corresponding first pad 411 of the printed circuit board 41 can cover an opening of the middle channel 422a facing toward the first pad 411. Referring to FIG. 7, a stopping portion 413 can be arranged around the first pad 411 of the printed circuit board 41. The stopping portion 413 is configured to stop the melted solder paste 70 from flowing to a region outside the first pad 411. The flexible circuit board 42 comes into contact with the stopping portion 413, so that a gap is formed between the second pad 422 of the flexible circuit board 42 and the corresponding first pad 411 of the printed circuit board 41. The gap may be configured to accommodate the solder paste 70, to reduce the possibility that the melted solder paste 70 is extruded between the second pad 422 and the corresponding first pad 411, thereby reducing the possibility that a connection force between the second pad 422 and the corresponding first pad 411 after the soldering is completed is relatively small due to a relatively small remaining amount of the solder paste 70 between the second pad 422 and the corresponding first pad 411.

After the second pads 422 of the flexible circuit board 42 and the corresponding first pads 411 of the printed circuit board 41 are connected by the solder joints 80, the bonding force between the second pads 422 and the solder joints 80 and the bonding force between the solder joints 80 and the corresponding first pads 411 are greater than the bonding force between the second pads 422 and the flexible dielectric layer 421.

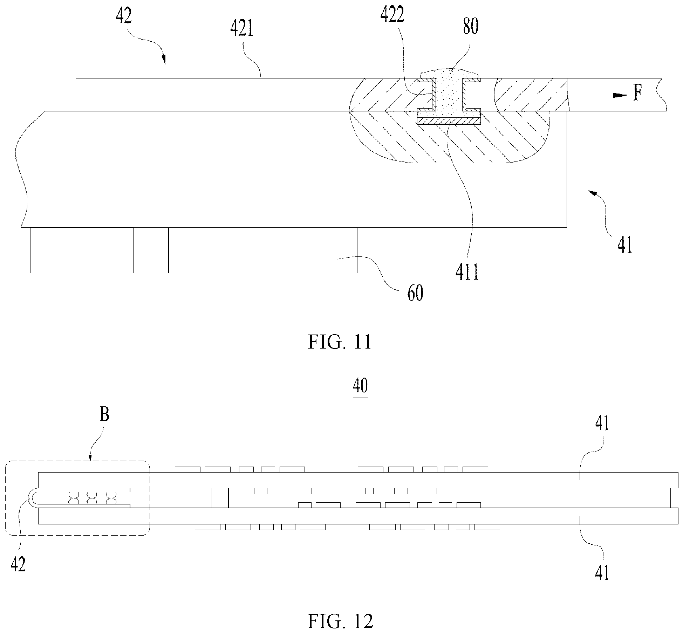

After the flexible circuit board 42 is bent, the flexible dielectric layer 421 of the flexible circuit board 42 is subjected to an external tensile force or its own rebound stress. FIG. 11 schematically shows a separated state of the flexible dielectric layer 421 and the second pads 422. Referring to FIG. 11, when an acting force to which the flexible dielectric layer 421 is subjected is greater than a bonding force between the flexible dielectric layer 421 and the second pads 422, the flexible dielectric layer 421 and the second pads 422 may be disconnected and separated. As a result, the flexible dielectric layer 421 and the second pads 422 are torn, causing the flexible circuit board 42 to fail and be scrapped due to damage, and further causing the circuit board assembly 40 to be scrapped. When the flexible dielectric layer 421 and the second pads 422 are torn, the metal traces 423 are disconnected from the second pads 422.

In the circuit board assembly 40 of the embodiments of this application, a compressive stress toward the printed circuit board 41 may be applied to the flexible circuit board 42 through the support 90, so that the flexible circuit board 42 snugly fits the printed circuit board 41, to reduce the possibility that the flexible circuit board 42 is displaced under an acting force, which is beneficial to reducing the possibility that the flexible dielectric layer 421 being subjected to a tensile force causes the flexible dielectric layer 421 and the second pad 422 to be disconnected from each other and torn.

The implementation of the circuit board assembly 40 provided in the embodiments of this application is described below.

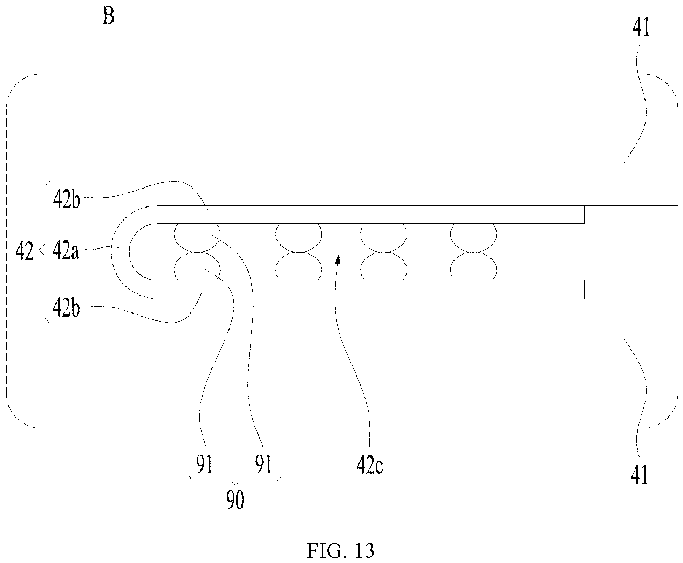

FIG. 12 schematically shows a structure of a circuit board assembly 40 according to an embodiment. Referring to FIG. 12 to FIG. 14, the embodiments of this application provide a circuit board assembly 40. The circuit board assembly 40 includes printed circuit boards 41, a flexible circuit board 42, and a support 90. Two printed circuit boards 41 are spaced apart. It should be noted that a quantity of the printed circuit boards 41 is not limited to two, and may also be three or more. There is a predetermined distance between two neighboring printed circuit boards 41. The printed circuit boards 41 include first pads 411. The flexible circuit board 42 includes a bending region 42a, straight regions 42b, and second pads 422. The bending region 42a of the flexible circuit board 42 is arranged in correspondence with a gap formed between the two printed circuit boards 41. The bending region 42a includes two opposite sides along its bending direction. Straight regions 42b are respectively arranged on the two opposite sides of the bending region 42a. The straight regions 42b arranged on the two sides are located between the two printed circuit boards 41. One straight region 42b is connected to one of the printed circuit boards 41, and an other straight region 42b is connected to the other printed circuit board 41. The bending region 42a and the straight regions 42b of the flexible circuit board 42 form an accommodating space 42c. The second pads 422 are arranged in the straight regions 42b. The first pads 411 of the printed circuit boards 41 are connected to the second pads 422 of the flexible circuit board 42. For example, the first pads 411 are connected to the second pads 422 by solder joints 80. The support 90 is arranged in the accommodating space 42c. The support 90 includes two stacked support bodies 91. It should be noted that the stacking means that the two support bodies 91 are arranged along one direction and come into contact with each other. Along a thickness direction of the printed circuit boards 41, the support bodies 91 are stacked. The support body 91 is abutted against the straight region 42b to apply a compressive stress toward the printed circuit board 41 to the straight region 42b.

In the embodiments of this application, the circuit board assembly 40 includes a bending flexible circuit board 42 and stacked printed circuit boards 41. The bending flexible circuit board 42 includes a bending region 42a and straight regions 42b. The straight regions 42b are connected to the printed circuit boards 41. A support 90 is arranged in an accommodating space 42c formed by the bending region 42a and the straight regions 42b. The support 90 includes two stacked support bodies 91. One support body 91 is abutted against one of the straight region 42b, and the other support body 91 is abutted against an other straight region 42b. The two support bodies 91 can respectively apply compressive stresses toward the printed circuit boards 41 to the corresponding straight regions 42b, to make the fitting between the straight regions 42b and the printed circuit boards 41 more snugly and relative positions between the straight regions 42b and the printed circuit boards 41 uneasy to change, thereby improving the stability and reliability of the connections between the straight regions 42B and the printed circuit boards 41. When the flexible circuit board 42 is subjected to an external force or its own rebound stress, the straight regions 42b of the flexible circuit board 42 are uneasy to have position changes relative to the printed circuit boards 41, thereby effectively reducing the possibility that due to movement of the straight regions 42b, the straight regions 42b and the printed circuit boards 41 are torn at joints formed by the first pads 411 and the second pads 422.

In advance, one end of the flexible circuit board 42 is connected to one of the printed circuit boards 41, and an other end thereof is connected to the other printed circuit board 41. Before the two printed circuit boards 41 are stacked, a support body 91 is arranged in a region in which the flexible circuit board 42 is connected to one of the printed circuit boards 41, and a support body 91 is arranged in a region in which the flexible circuit board 42 is connected to the other printed circuit board 41. After the two printed circuit boards 41 are stacked, the flexible circuit board 42 is in a bending state, and at the same time, the two support bodies 91 abut each other. It should be noted that abutting refers to a connection manner of coming into contact and abutting.

The flexible circuit board 42 includes a flexible dielectric layer 421. The second pads 422 are arranged in the flexible dielectric layer 421. The support bodies 91 are abutted against the flexible dielectric layer, to press the flexible dielectric layer tightly. Because the support bodies 91 limit and restrain the straight regions 42b, when the bending region 42a is subjected to an external force, for example, when the bending region 42a is squeezed and collided, or the bending region 42a is subjected to its down rebound stress, the acting force is unlikely to be transferred from the flexible dielectric layer 421 of the bending region 42a to the flexible dielectric layers 421 of the straight regions 42b, so that the tensile force is unlikely to act between the flexible dielectric layer 421 and the second pads 422, thereby effectively reducing the possibility that due to bearing a relatively large tensile force, the flexible dielectric layer 421 is separated from the second pads 422 and torn, and also reducing the possibility that due to bearing a relatively large tensile force, the second pads 422 are separated from the first pads 411.

The second pad 422 is at least partially arranged between the support body 91 and the printed circuit board 41. The support body 91 includes a bottom surface 911 facing toward the flexible circuit board 42 and a top surface 912 facing away from the flexible circuit board 42. The second pad 422 is at least partially located below the bottom surface 911 of the support body 91 and occluded by the support body 91. An orthographic projection of the second pad 422 on the printed circuit board 41 overlaps with an orthographic projection of the support body 91 on the printed circuit board 41. The support body 91 may be abutted against the flexible dielectric layer 421 close to the second pad 422, to help reduce the possibility of separation between the flexible dielectric layer 421 and the second pad 422 caused by a position change of the flexible dielectric layer 421 near the second pad 422 relative to the second pad 422 after the flexible dielectric layer 421 is subjected to a force. For example, the second pad 422 is entirely occluded by the support body 91. A region in which the support body 91 comes into contact with the flexible dielectric layer 421 surrounds the second pad 422. A region of the flexible dielectric layer 421 surrounding the second pad 422 is abutted against by the support body 91, so that all regions of the flexible dielectric layer 421 surrounding the second pads 422 are unlikely to have position changes relative to the second pads 422, thereby further reducing the possibility of separation between the flexible dielectric layer 421 and the second pads 422.

The support body 91 is an elastomer having compression and resilience performance. When being subjected to an external force, the support body 91 itself can compress and deform, and can return to its original shape after the external force is removed. The material of the support body 91 may be selected from flexible materials, such as foam, silica gel, or rubber. One printed circuit board 41 in the two printed circuit boards 41 is folded and stacked onto the other printed circuit board 41, to make the two support bodies 91 come into contact with each other. Then, the printed circuit board 41 is continuously folded, the two support bodies 91 compress each other to deform. The two printed circuit boards 41 squeeze the supports 90 to each other, so that the support bodies 91 are in a state of squeezing each other. Because the support bodies 91 can compress and deform, when there are different requirements for the distance between the two printed circuit boards 41, the support bodies 91 can also be well adapted to the space change, thereby reducing the possibility of relatively high production costs and assembly costs caused by the machining and manufacturing of support bodies 91 of different sizes. Under the action of its own rebound stress, the support body 91 is further beneficial to increasing the compressive stress applied to the flexible dielectric layer 421, to make the flexible dielectric layer 421 fit the printed circuit board 41 more snugly. During use of the circuit board assembly 40, when a loosened connection between the printed circuit boards 41 increases the distance therebetween, the support body 91 can rebound to compensate for the increased distance between the printed circuit boards 41, so that the support body 91 can still press the flexible circuit board 42 tightly, thereby reducing the possibility that the support body 91 fails because the compressive stress applied by the support body 91 to the flexible circuit board 42 decrease or disappears.

In some feasible manners, after the two printed circuit boards 41 are stacked, and the flexible circuit board 42 is bent, the support body 91 is then placed in the accommodating space 42c, and the support body 91 is adjusted to a predetermined position. The support body 91 keeps in contact with, but is not connected to, the straight region 42b of the flexible circuit board 42, so that when the support body 91 is subjected to an external force, the support body 91 can move relative to the straight region 42b.

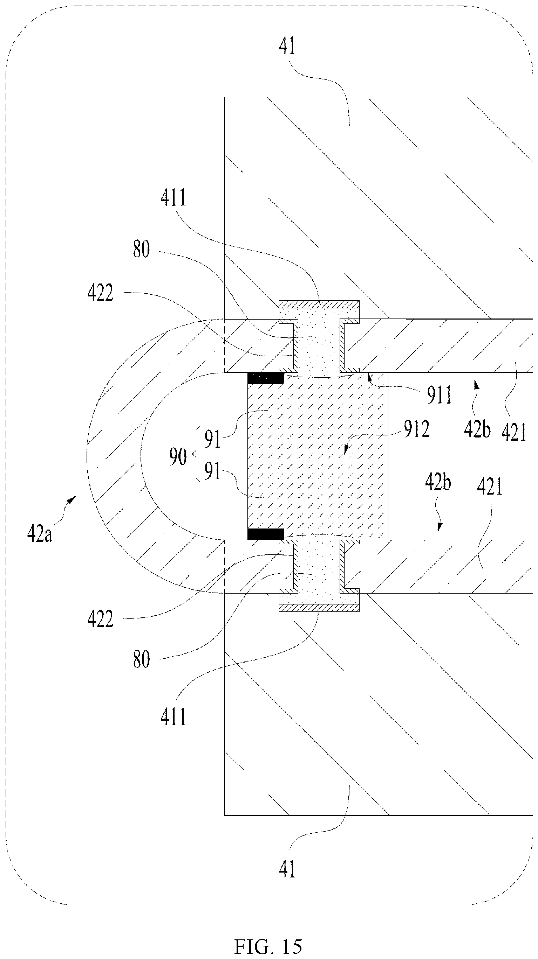

In some feasible manners, FIG. 15 schematically shows a partial cross-sectional structure of a circuit board assembly 40 according to another embodiment. Referring to FIG. 15, a part of the support body 91 facing toward the bottom surface 911 of the straight region 42 is connected to the straight region 42b. Apart of the support body 91 close to the bending region 42a is connected to the flexible circuit board 42, and a part thereof away from the bending region 42a is in contact with, but is not connected to, the flexible circuit board 42. Therefore, on the one hand, after connections between the two printed circuit boards 41 and the flexible circuit board 42 are completed, the support body 91 is connected to a predetermined position of the flexible circuit board 42, and then, the two printed circuit boards 41 are further stacked, and the flexible circuit board 42 is bent, which is beneficial to ensuring the precision of the mounting position of the support body 91. On the other hand, in the circuit board assembly 40 that has been completely assembled, when the support body 91 is subjected to an external force, the support body 91 is unlikely to be misplaced, thereby reducing the possibility that the support body 91 cannot be abutted against the straight region 42b anymore because misplacement of the support body 91 releases the two support bodies 91 from a stacked state.

When the support body 91 is an elastomer, a part of the support body 91 facing toward the bottom surface 911 of the straight region 42b is connected to the straight region 42b, and an other part thereof is in contact with, but is not connected to, the straight region 42b. When the support body 91 is compressed by pressure and deforms, the part of the support body 91 that is not connected to the straight region 42b may not be limited or restrained by the straight region 42 and can freely expand outward, which is beneficial to dispersing the rebound stress of the support body 91, thereby reducing the possibility the metal trace 423 is pulled off by a relatively large tensile force exerted by the compressed support body 91 on the straight region 42b due to the relatively large elastic potential energy accumulated by the support body 91.

The support body 91 is bonded to the straight region 42b of the flexible circuit board 42. The support body 91 can be bonded to the straight region 42b through an adhesive or a double-sided adhesive tape. Use of a bonding manner can reduce a quantity of used connectors, and does not require correspondingly designing the structure of the support body 91 or the straight region 42b of the flexible circuit board 42 to adapt to connectors, which is beneficial to reducing the complexity of structural machining of the support body 91 and the flexible circuit board 42 and the difficulty of assembly of the support body 91 and the flexible circuit board 42. For example, an adhesive or a double-sided adhesive tape is arranged in a plurality of different regions of the bottom surface 911 of the support body 91, or an adhesive or a double-sided adhesive tape is arranged on the whole bottom surface 911 of the support body 91, and then, bonds the support body 91 to a predetermined position on the flexible circuit board 42

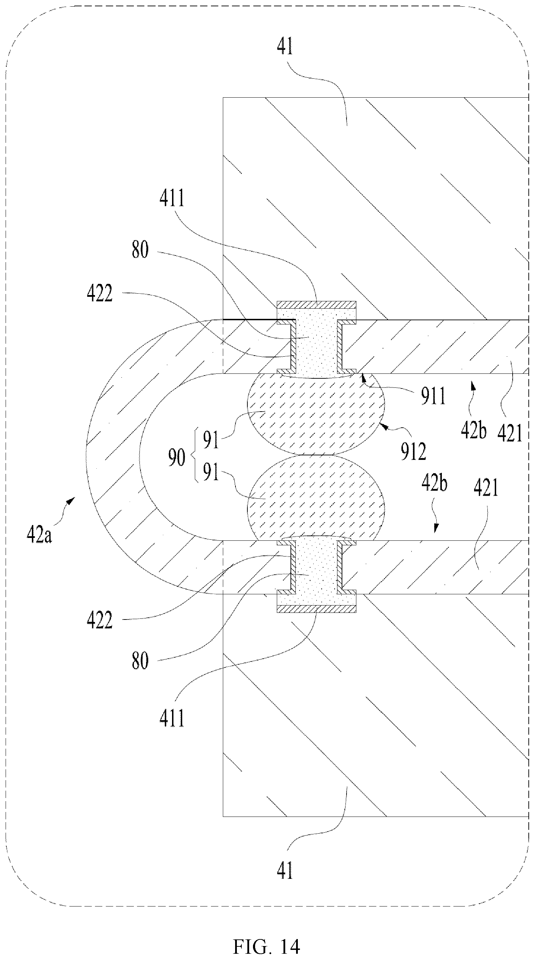

Referring to FIG. 15, a cross-sectional area of the support body 91 can remain unchanged along a direction away from the second pad 422. For example, the support body 91 can be a cylinder or a prism as a whole. A cross section of the support body 91 is perpendicular to the direction away from the second pad 422. The direction away from the second pad 422 can be parallel to the thickness direction of the printed circuit board 41. In some other examples, referring to FIG. 14, a cross-sectional area of the support body 91 can decrease along a direction away from the second pad 422. For example, the cross-sectional area of the support body 91 decreases along the direction away from the second pad 422. For example, the support body 91 can be a cone, a pyramid, a hemisphere, or a semi ellipsoid.

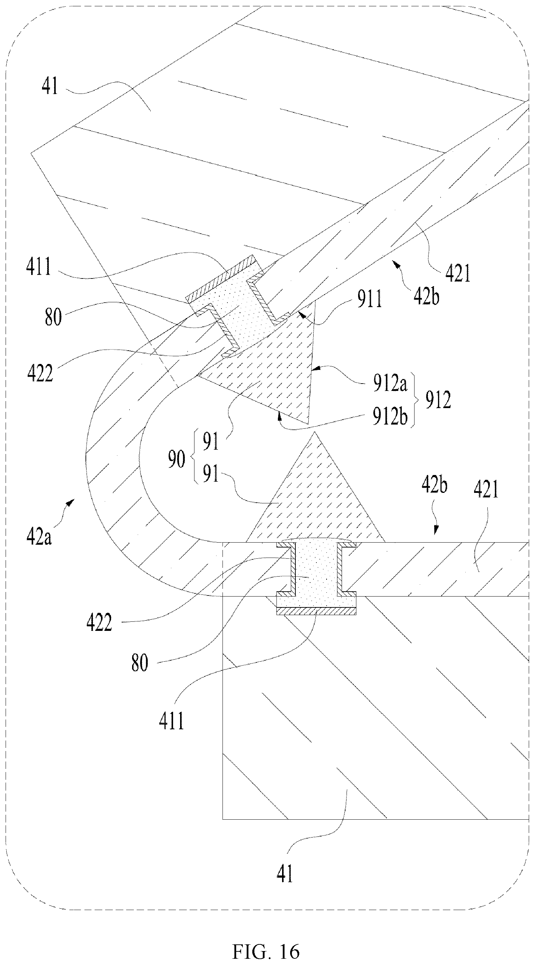

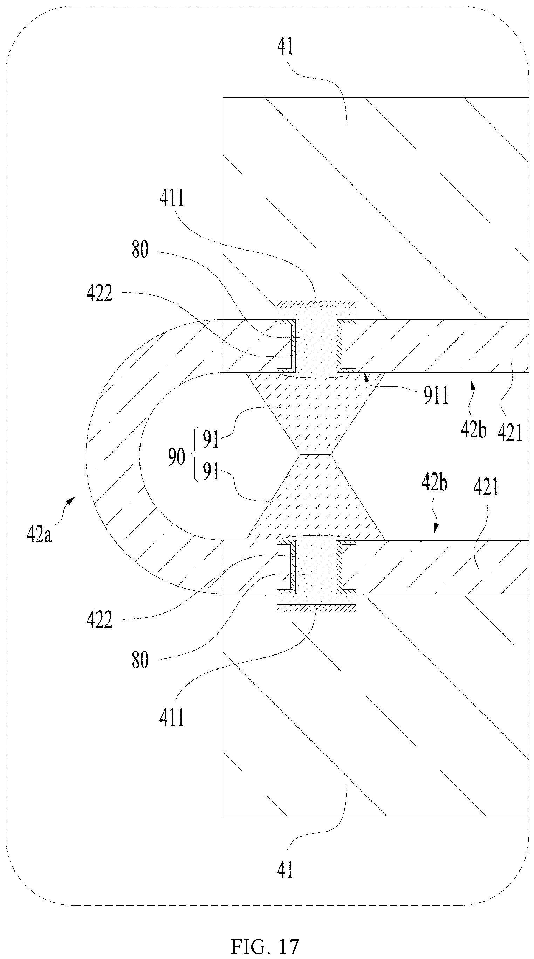

In some examples, referring to FIG. 15, the top surface 912 of the support body 91 facing away from the second pad 422 is a flat surface. For example, the support body 91 may be a solid prism or pyramid. In other examples, FIG. 16 schematically shows a partial cross-sectional structure of a circuit board assembly 40 according to another embodiment in a first state. Referring to FIG. 16, one printed circuit board 41 is folded by a predetermined angle and forms a predetermined angle with the other printed circuit board 41, but the two support bodies 91 do not come into contact with each other. The top surface 912 of the support body 91 facing away from the second pad 422 includes a first flat surface 912a and a second flat surface 912b. The first flat surface 912a intersects the second flat surface 912b. For example, a cross section of the support body 91 is triangular. It should be noted that the cross section of the support body 91 is parallel to the thickness direction of the printed circuit board 41. FIG. 17 schematically shows a partial cross-sectional structure of the circuit board assembly 40 in a second state. Referring to FIG. 17, after being folded by 180°, one printed circuit board 41 is stacked with the other printed circuit board 41, and the two support bodies 91 are abutted against each other under the squeezing effect of the two printed circuit boards 41. After the two printed circuit boards 41 are folded and stacked, the flexible circuit board 42 is in a bending state. Because a sum of thicknesses of the two support bodies 91 before being compressed is greater than a distance between the two printed circuit boards 41, the two printed circuit boards 41 squeeze the two support bodies 91. In the support 90, a top of one of the support bodies 91 is abutted against a top of the other support body 91, so that the two support bodies 91 are compressed and deformed.

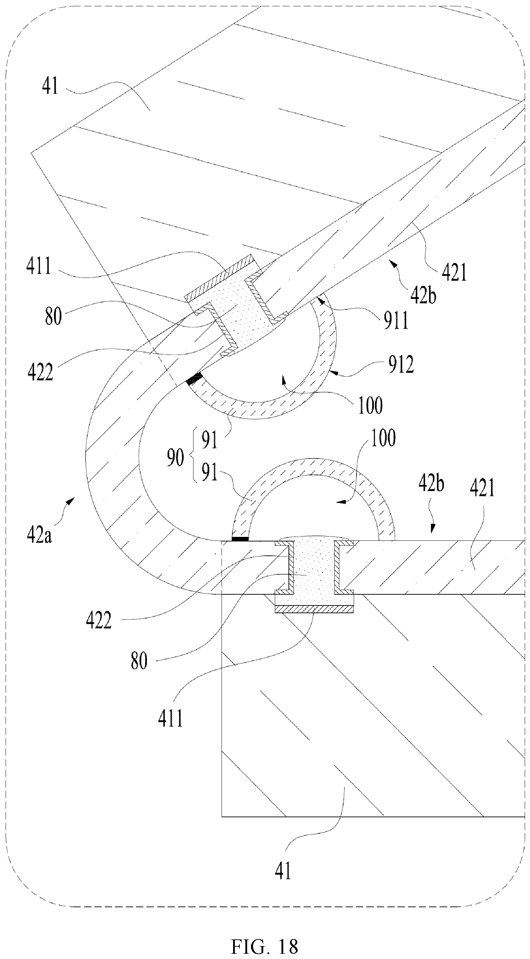

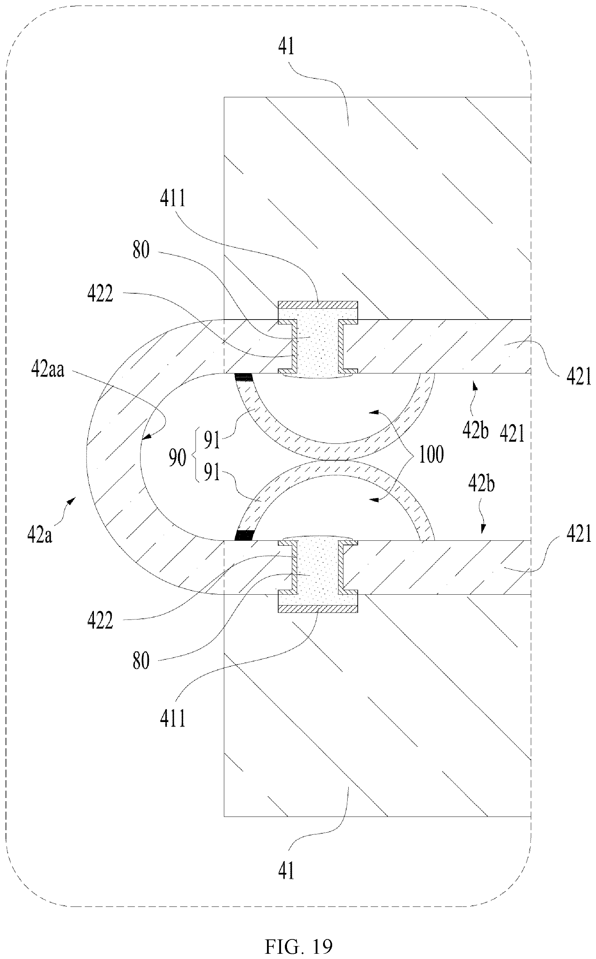

In some examples, referring to FIG. 14, the top surface 912 of the support body 91 facing away from the second pad 422 is a curved surface. When the two support bodies 91 abut each other, the respective top surfaces 912 of the two support bodies 91 are unlikely to have a stress concentration region. For example, the support body 91 may be a solid hemisphere. The bottom surface 911 of the support body 91 is circular. A half of a region of the bottom surface 911 can be connected to the flexible circuit board 42, and the other half of the region is in contact with, but is not connected to, the flexible circuit board 42 When the support body 91 is compressed, the part of the support body 91 that is in contact with, but is not connected to, the flexible circuit board 42 can expand outward, so that the support body 91 is flatter as a whole. For example, FIG. 18 schematically shows a partial cross-sectional structure of a circuit board assembly 40 according to another embodiment in a first state. Referring to FIG. 18, one printed circuit board 41 is folded by a predetermined angle and forms a predetermined angle with the other printed circuit board 41, but the two support bodies 91 do not come into contact with each other. The support body 91 may be a curved structure. End surfaces of two free ends of the support body 91 can form the bottom surface 911 of the support body 91. One end surface of the support body 91 is connected to the flexible circuit board 42, and the other end surface is in contact with, but is not connected to, the flexible circuit board 42. FIG. 19 schematically shows a partial cross-sectional structure of the circuit board assembly 40 in a second state. Referring to FIG. 19, after being folded by 180°, one printed circuit board 41 is stacked with the other printed circuit board 41, and the two support bodies 91 are abutted against each other under the squeezing effect of the two printed circuit boards 41. When the support body 91 is compressed, an end of the support body 91 that is in contact with, but is not connected to, the flexible circuit board 42 can move outward, so that the support body 91 is flatter as a whole.

Referring to FIG. 19, a cavity 100 is formed between the support body 91 and the straight region 42b of the flexible circuit board 42. The second pad 422 is located in the cavity 100. When the first pad 411 of the printed circuit board 41 is connected to the second pad 422 by soldering, a part of the solder joint 80 outside the second pad 422 protrudes from a surface of the straight region 42b. The second pad 422 is entirely located in the cavity 100, so that the support body 91 can avoid the second pad 422 and the protruding part of the solder joint 80. A region in which the support body 91 is in contact with the straight region 42b surrounds the second pad 422 and the protruding part of the solder joint 80, so that the support body 91 can compress a region of the flexible dielectric layer 421 surrounding the second pad 422 tightly. The manner in which the support body 91 avoids the second pad 422 can reduce the possibility that the support body 91 cannot be abutted against a region of the flexible dielectric layer 421 near the second pad 422 due to a gap formed between the support body 91 and the region of the flexible dielectric layer 421 near the second pad 422 caused by the protruding part of the solder joint 80 supporting the support body 91.

Two or more second pads 422 are arranged in each straight region 42b of the flexible circuit board 42. The two or more second pads 422 can be distributed in a plurality of columns. Each support body 91 is arranged in correspondence to two or more second pads 422. After the printed circuit boards 41 are folded and stacked, each support body 91 can simultaneously apply a compressive stress to regions of the flexible dielectric layer 421 surrounding a plurality of second pads 422. For example, each support body 91 is arranged in correspondence to all the pads in the straight region 42b. After connections between the flexible circuit board 42 and the printed circuit boards 41 are completed, only one support body 91 needs to be arranged on the flexible circuit board 42 to occlude all the pads, which is beneficial to reducing the difficulty of assembly of the support body 91 and flexible circuit board 42.

In some other examples, two or more supports 90 are arranged in in the accommodating space 42c of the flexible circuit board 42. A quantity and positions of the supports 90 have a one-to-one correspondence with a quantity and positions of the second pads 422. Each second pad 422 in a straight region 42b corresponds to one support 90. Two neighboring supports 90 are spaced apart from each other. Adopting the manner of dispersing a plurality of supports 90, on the one hand, is beneficial to reducing the material usage of the supports 90 and reducing production costs, and on the other hand, can reduce airflow blockage caused by the supports 90 since the two neighboring support bodies 91 are spaced apart, which is beneficial to flowing of airflows and ensures good heat dissipation.

In some feasible manners, in the two straight regions 42b, a quantity and positions of second pads 422 arranged in one straight region 42b are set in a one-to-one correspondence with a quantity and positions of second pads 422 arranged in the other straight region 42b. Each support body 91 may be an integral structure. Alternatively, each support body 91 may also be a multi-layer structure. For example, the two neighboring layer structures are bonded and fixed, so that the thickness of the support body 91 can be flexibly adjusted through a quantity of layer structures according to the product requirements.

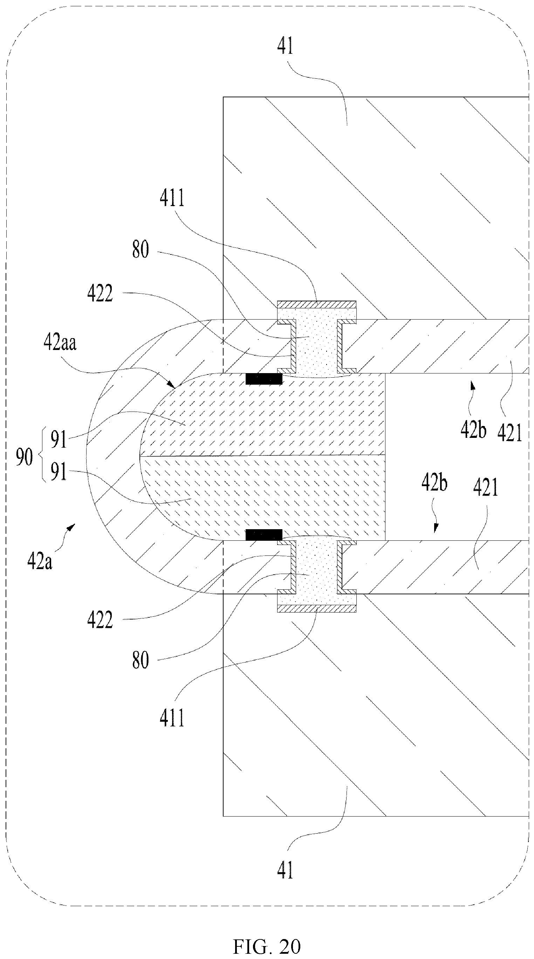

FIG. 20 schematically shows a partial cross-sectional structure of a circuit board assembly 40 according to an embodiment. Referring to FIG. 20, the bending region 42a of the flexible circuit board 42 includes an inner surface 42aa facing toward the accommodating space 42c. The inner surface 42aa of the bending region 42a is in contact with the support body 91. The support body 91 can provide a supporting force to the bending region 42a in the contact region, which is beneficial to reducing the possibility that the bending region 42a is depressed toward the accommodating space 42c after being subjected to an acting force, thereby, on the one hand, reducing the possibility that the bending region 42a pulls the straight region 42b due to the depression of the bending region 42a, to make the straight region 42b be subjected to a relatively large tensile force and be torn, and on the other hand, reducing the possibility that the metal traces 423 of the bending region 42a are folded and broken due to the depression of the bending region 42a. For example, the entire inner surface of the bending region 42a is in contact with the support 90.

In the description of the embodiments of this application, it should be noted that, unless specified or limited otherwise, the terms "mount", "connect", and "connection" should be understood broadly, for example, which may be fixed connection, indirectly connected to each other through an intermediate medium, or communication inside two elements or an interaction relationship between two elements. A person of ordinary skill in the art may understand the specific meanings of the foregoing terms in the embodiments of this application according to specific situations.

In the embodiments of this application, it is implied that an apparatus or element in question needs to have a particular orientation, or needs to be constructed and operated in a particular orientation, and therefore cannot be construed as a limitation on the embodiments of this application. In the description of the embodiments of this application, unless otherwise exactly and specifically ruled, "a plurality of" means two or more.

The terms such as "first", "second", "third", and "fourth" (if any) in the specification and claims of the embodiments of this application and in the accompanying drawings are used for distinguishing between similar objects and not necessarily used for describing any particular order or sequence. It should to be understood that the data termed in such a way are interchangeable in proper circumstances so that the embodiments of this application described herein can be implemented in orders except the order illustrated or described herein. Moreover, the terms "include", "comprise", and any other variants thereof mean are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects. In a formula, the character "/" indicates a "division" relationship between the associated objects.

It may be understood that, various reference numerals in the embodiments of this application are merely for differentiation for ease of description, and are not intended to limit the scope of the embodiments of this application.

It may be understood that, sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

## Claims

1. A circuit board assembly, applied to an electronic device, comprising at least:
printed circuit boards, wherein two or more printed circuit boards are spaced apart, and the printed circuit boards comprise first pads;
a flexible circuit board, wherein two neighboring printed circuit boards are connected to the flexible circuit board, the flexible circuit board comprises a bending region, straight regions, and second pads, the straight regions are arranged on two opposite sides of the bending region, the straight regions are located between the two printed circuit boards, the bending region and the straight regions form an accommodating space, the second pads are arranged in the straight regions, and the first pads are connected to the second pads; and
a support, arranged in the accommodating space, wherein the support comprises two stacked support bodies, and the support body is abutted against the straight region to apply a compressive stress toward the printed circuit board to the straight region.

2. The circuit board assembly according to claim 1, wherein the flexible circuit board comprises a flexible dielectric layer, the second pads are connected to the flexible dielectric layer, and the support body is abutted against the flexible dielectric layer.

3. The circuit board assembly according to claim 1 or 2, wherein the second pad is at least partially arranged between the support body and the printed circuit board.

4. The circuit board assembly according to any one of claims 1 to 3, wherein the support body is an elastomer.

5. The circuit board assembly according to any one of claims 1 to 4, wherein the support body comprises a bottom surface facing toward the straight region, and at least a part of the bottom surface is connected to the straight region.

6. The circuit board assembly according to any one of claims 1 to 5, wherein a cross-sectional area of the support body decreases along a direction away from the second pad.

7. The circuit board assembly according to any one of claims 1 to 6, wherein a cavity is formed between the support body and the straight region, and the second pad is located in the cavity.

8. The circuit board assembly according to any one of claims 1 to 7, wherein a top surface of the support body facing away from the second pad is a curved surface or a flat surface; or a top surface of the support body facing away from the second pad comprises a first flat surface and second flat surface, wherein the first flat surface intersects the second flat surface.

9. The circuit board assembly according to any one of claims 1 to 8, wherein each of the support bodies is arranged in correspondence to two or more second pads.

10. The circuit board assembly according to any one of claims 1 to 8, wherein the two or more supports are arranged in the accommodating space, and a quantity and positions of the supports have a one-to-one correspondence with a quantity and positions of the second pads.

11. The circuit board assembly according to any one of claims 1 to 10, wherein the support body is bonded to the straight region.

12. The circuit board assembly according to any one of claims 1 to 11, wherein an inner surface of the bending region facing toward the accommodating space comes into contact with the support body.

13. An electronic device, comprising the circuit board assembly according to any one of claims 1 to 12.
